# EUROPEAN PATENT SPECIFICATION

(11) **EP 4 530 651 B1**
(45) Date of publication and mention of the grant of the patent: **29.10.2025**
(21) Application number: 23315367.5
(22) Date of filing: 26.09.2023
(51) Int. Cl.: G01R 33/30, G01R 33/3873, G01R 33/44, G01R 33/3815, G01R 33/421

(54) **FAST SWITCH FIELD COMBINED NMR DEVICE FOR 2FNMR**
NMR-VORRICHTUNG MIT KOMBINIERTEM SCHNELLSCHALTFELD FÜR 2FNMR
DISPOSITIF RMN À CHAMPS COMBINÉS ET À COMMUTATION RAPIDE POUR 2FNMR

(43) Date of publication of application: 02.04.2025
(73) Proprietor: Bruker France S.A.S., 67166 Wissembourg Cédex (FR)
(72) Inventor: TYBURN, Jean-Max, 67160 Wissembourg (FR); BRÉHAM, Sébastien, 67160 Wissembourg (FR); BEYER, Eric, 67470 Eberbach-Seltz (FR)
(74) Representative: Kohler Schmid Möbus Patentanwälte

(56) References cited:
- EP-A1- 4 071 492
- US-A1- 2016 076 924
- US-B2- 11 579 224
- ALEXEY S. KIRYUTIN ET AL: "A fast field-cycling device for high-resolution NMR: Design and application to spin relaxation and hyperpolarization experiments", JOURNAL OF MAGNETIC RESONANCE., vol. 263, 29 December 2015 (2015-12-29), US, pages 79 - 91, XP055547226, ISSN: 1090-7807, DOI: 10.1016/j.jmr.2015.11.017
- MILANI JONAS ET AL: "A magnetic tunnel to shelter hyperpolarized fluids", REVIEW OF SCIENTIFIC INSTRUMENTS, vol. 86, no. 2, February 2015 (2015-02-01), pages 1 - 8, XP012195150, ISSN: 0034-6748, [retrieved on 19010101], DOI: 10.1063/1.4908196
- COUSIN SAMUEL F ET AL: "Recovering Invisible Signals by Two-Field NMR Spectroscopy", ANGEWANDTE CHEMIE (INTERNATIONAL ED.), 16 August 2016 (2016-08-16), pages 9886 - 9889, XP055904869, Retrieved from the Internet <URL:https://onlinelibrary.wiley.com/doi/10.1002/anie.201602978> [retrieved on 20220324], DOI: 10.1002/anie.201602978

## Description

The invention relates to a Two-Field Nuclear Magnetic Resonance spectrometer adapted for performing field-cycling techniques NMR relaxometry experiments comprising
- a high field superconducting NMR magnet system for generating a homogenous magnetic field parallel to a z-axis in a central region of the two-field-NMR spectrometer for polarization of an NMR sample and for detection of NMR signals;
- a low field magnet system arranged to generate a variable homogenous magnetic field; - - a magnetic tunnel connecting the center of the high field superconducting NMR magnet system with the low field magnet system; and
- a shuttle system designed for shuttling the NMR sample between the high field superconducting NMR magnet system and the low field permanent magnet system;
wherein the magnetic tunnel is provided with a further magnet system; and
wherein the high field superconducting NMR magnet system, the magnetic tunnel and the low field magnet system are arranged coaxially about the z-axis along a bore of the high field superconducting NMR magnet system.

A Two-Field Nuclear Magnetic Resonance spectrometer with the features defined above is known from US 11,579,224 B2 (= **Reference [7]**).

A field-cycling NMR spectrometer comprising high field superconducting NMR magnet, a low field magnet system and a shuttle system is known from EP 4 071 492 B1 (= **Reference [1]**).

### Technical background of the invention

In general, the present invention relates to the technical field of magnetic resonance. Nuclear magnetic resonance (="NMR") spectroscopy is a powerful tool in instrumental chemical analysis and a commercially widespread method for analyzing and characterizing the chemical composition of substances. In NMR experiments, a sample is exposed to a strong static magnetic field, which interacts with spins of nuclei contained in the sample. Radio frequency (="RF") pulses are sent into the sample for manipulating the spins, and the sample's reaction, i.e. RF signals (also called "NMR signals") are measured. The sample's reaction depends on the environment of the nuclei in the sample, in particular bonding electrons. Accordingly, information about the chemical structure of the sample can be obtained by analysing the NMR signals measured.

Improvements of NMR methods like field-cycling allow exploiting interaction of nuclear spins with magnetic fields of different strengths, by means of which more spectroscopic information about the sample becomes accessible. Field-cycling techniques in NMR have been applied on various field dependent studies. The main idea is to measure the relaxation in the frequency basis. Its applications include material science, such as polymer dynamics, and structural biology, such as membrane dynamics and protein dynamics, and relaxation measurements on contrast agent in MRI field, etc.

In particular, in two-field NMR (="2F-NMR") experiments, nuclear spins may be exposed to and manipulated by means of RF pulses at two different magnetic field strengths. This allows obtaining additional spectroscopic information about the sample, in particular dynamic information or an additional measurement dimension, which may be used to increase resolution, in particular to identify maxima in spectra more reliably.

At a first working volume equipped with the first NMR probe, a first field strength ("high field") with a high homogeneity is present, allowing in particular a strong initial polarization and a signal detection with high resolution and high sensitivity. Further, nuclear spin manipulations may be done at the first working volume. At a second working volume equipped with the second NMR probe, a second field strength ("low field") with an at least fairly good homogeneity is present, which also allows nuclear spin manipulations , in particular band-selective manipulations of spins.

For numerous nuclear spin systems, the coupling properties and/or the relaxation times depend on the magnetic field strength present. Accordingly, since there are two different field strengths available, a 2F-NMR apparatus may perform experiments, which make use of the different coupling properties and/or relaxation times in the same single measurement.

This provides additional information about the sample in spectroscopy applications. In particular, dynamic information (movement information) about nuclei in the sample or molecules containing said nuclei may be obtained. Thus, an additional dimension of NMR measurement of the sample becomes available. This additional dimension is based on a different second field strength and therefore on a different physical behaviour, as compared to the physical behaviour at the first field strength. In other words, the development of a spin system in the sample is different at the first and second field strength.

The temporal exposure of the sample to a variable relaxation field can be performed either by electronically switching the current in a magnet coil or by moving the sample mechanically between positions of different magnetic flux densities. The latter field-cycling variant is also referred to as 'sample shuttle technique' being used in the present invention. Good electronically switched relaxometers have a field switching and settling time to the required accuracy and stability in the order of a millisecond, whereas sample shuttling times can be achieved in less than 100ms (see e.g. Reference [1]).

### Special prior art

Rainer Kimmich and Esteban Anoardo, "Field-cycling NMR relaxometry", Progress in Nuclear Magnetic Resonance Spectroscopy 44 (2004) 257-320 (= **Reference [2]**) give a general overview of the FFC NMR principles.

In a typical 2-field NMR experiment, the sample is first exposed to a first, strong magnetic field at a first location (first magnetic center, first sample volume) and then moved to a second location (second magnetic center, second sample volume) of a second, weaker magnetic field in which nuclear spins are relaxed and/or manipulated, and finally the sample is brought back to the location of the first, strong magnetic field where the actual NMR measurement takes place.

At the first location, the sample is polarized in a magnetic field with a flux density as high as technically feasible. The relaxation process takes place in a low-field interval varied with respect to length and lower flux density. The signal remaining after this relaxation interval is detected in a further field of fixed flux density again as high as possible.

At the second location, the polarization can be transferred to a desired atomic nucleus, as a result of which the NMR signal of this atomic nucleus can be amplified in the subsequent NMR measurement. In order to preserve the transferred polarization as much as possible when the sample is transported between the second location and the first location, this transport should take place quickly, for which a short path between the second location and the first location is desired.

EP 3 081 954 B1 (= **Reference [3]**) in detail describes 2F-NMR measurements involving a sample in a first working volume of a highly homogeneous magnetic field with a first field strength and transferring the sample to a second working volume with a magnetic field having lower homogeneity at a second field strength. A sample carrier is provided for transporting the sample between the first working volume and the second working volume.

The usual structure of a magnet system of a 2-field NMR spectrometer comprises a superconducting magnet (magnetic coil) in a cryostat. The first sample volume (first magnetic center) is formed in the magnetic center of the superconducting magnet which is located in the room temperature bore of the cryostat. The second sample volume (second magnetic center) is in the room temperature bore in the stray field of the superconducting magnet, an approximately homogeneous magnetic field being generated locally by means of ferromagnetic shims. This magnet structure can be produced using a standard NMR system by installing the ferromagnetic shims in the room temperature bore. The disadvantage of this magnet structure is that the field strength in the second sample volume is limited to approximately 0.5 Tesla or less. Furthermore, the field strength in the second sample volume is not freely adjustable. When the ferromagnetic shims are arranged in the room temperature bore, the installation space is also considerably restricted.

US 2016/0076924 A1 (= **Reference [4]**) describes a field cycling magnetic resonance based method and apparatus to measure and analyze flow properties in flowing complex. The pre-polarization magnet is a Halbach magnet through which the fluids flow. Relaxation of the magnetizations is performed in a second magnetic field region of variable intensity, and the measuring step is done in a third magnetic field region on an NMR measurement module. Due to the flow-nature of this experiment, the according apparatus does not comprise any shuttle system.

WO 2011/151049 A1 (= **Reference [5]**) describes a method and a device for carrying out a nuclear spin relaxometry method for determining the longitudinal relaxation behavior of nuclear spins of a sample. The method comprises the steps of pre-polarization, evolution and detection. The pre-polarization of nuclear spins of a sample takes place in a large magnetic field with a magnitude of up to one Tesla. When the nuclear spin magnetization has reached a saturation state, a sufficiently fast (non-adiabatic) switching of the magnetic field to a small, adjustable evolutionary magnetic field takes place in such a way that the nuclear spins cannot follow. At the end of the evolution period, there is again a switchover of the magnetic field to a detection magnetic field, with the z-component of the magnetization being registered in the detection magnetic field. Switching between the different fields is achieved with appropriate coil arrangements and their rapid switching. A transport of the sample is not described. Thus, this known 2-field NMR experiment is also performed without a shuttle. In addition, the very different magnetic fields of extremely variable strengths are generated by only a single magnet system.

Zhoukov et al., "Field-cycling NMR experiments in an ultra-wide magnetic field range: relaxation and coherent polarization transfer", Phys. Chem. Chem. Phys., 2018, 20, 12396-12405 (= **Reference [6]**) studied the relaxation and polarization transfer phenomena by using a shuttle system and measuring the magnetic field dependence of T1-relaxation times over the field range from 10nT to 9.4T in the heteronuclear spin systems. The shuttle system comprises a carriage, which is mechanically moved by a rack-and-gear system with a relatively slow transfer time of about 0.5s. This slow transfer time leads to a loss in polarization. To go to fields below 2mT a magnetic shield is mounted on top of the NMR spectrometer; inside the shield the field is low. To vary the field in the range below 2mT the current in the magnetic coils located inside the shield is adjusted. Additional shim coils are used to compensate linear and quadratic magnetic field gradients.

Alexey S. Kiryutin et al. in their article "A fast field-cycling device for high-resolution NMR: Design and application to spin relaxation and hyperpolarization experiments" (= **Reference [8]**) study polarization transfer between protons and hetero-nuclei at strong coupling, which can only proceed at very low fields, typically, of 10µT or lower. In such experiments, it is necessary to perform active shielding of residual magnetic fields, longitudinal and transverse. Reference [8], however, is silent about using a passive ferromagnetic shielding tube.

Reference [7] already cited at the top page_describes a magnet system for 2-field NMR experiments, comprising a superconducting main field magnet for generating a first magnetic field in a first sample volume, a superconducting additional field magnet for generating a second magnetic field in a second sample volume, and a cryostat having a cooled main coil container, having an evacuated room temperature covering, and having a RT bore which extends through the main field magnet and through the additional field magnet. The magnet system comprises a cooled additional coil container in a vacuum. The RT covering has a flange connection with an opening through which the RT bore extends. A front end of the additional coil container protrudes through the flange opening into the RT covering such that the additional field magnet also at least partly protrudes through the flange opening into the RT covering. A closure structure which seals the RT covering between the flange connection and the RT bore is installed on the flange connection. This makes 2-field NMR spectroscopy which can be used flexibly and has good signal strength.

Reference [1] also cited at the top page describes a generic two-field NMR spectrometer comprising a high field superconducting NMR magnet system bridged by a magnetic tunnel with a low field magnet system generating a variable homogenous magnetic field and a shuttle system designed for shuttling the NMR sample between the high field superconducting NMR magnet system and the low field permanent magnet system. In particular, Reference [1] describes in detail a transfer device being part of the shuttle assembly.

### Objects of the invention

It is an object of the present invention to present an improved generic two-field NMR spectrometer allowing fast field-cycling NMR experiments over a wide range of magnetic fields, preferably from very low 100µT to very high 29.3T.

In particular, the invention aims at
- very homogeneous low fields
- excellent resolution of detected spectra at high fields
- high detection sensitivity
- preserving as much as possible the lifetime of manipulated spins.

One issue of the invention is to overcome the loss of polarization due to a spin-spin relaxation during shuttling.

Also, the influence of the two magnet systems to each other, i.e. the polarization high field magnet and the low field magnet, should be minimized.

Another object of the present invention is to provide a system allowing relaxometry measurements with a higher sensitivity than in the prior art by providing an evolution field magnet which has a high homogeneity at a very low field. It is apparent to the expert that the arrangement of the low-field magnet and its shielding against both the earth's magnetic field and the high-field magnet represent a major technical challenge.

### Brief description of the invention

This object is achieved, in accordance with the present invention and in a surprisingly simple and effective way, by a two-field-NMR spectrometer wherein the low field permanent magnet system comprises a cylindrical ferromagnetic part, in particular comprising µ-metal, for shielding non-homogeneous external magnetic disturbance fields at low flux densities; wherein the low field system comprises a low field coil arranged inside the cylindrical ferromagnetic part configured to produce magnetic fields at flux densities below the magnetic saturation of the ferromagnetic part; and wherein the low field system comprises a high field coil arranged outside the cylindrical ferromagnetic part configured to generate magnetic fields at flux densities above the magnetic saturation of the ferromagnetic part.

The low field coil is needed to generate fields in the range between 100µT and a few mT. Otherwise the field created by the coils would be shielded and the field at the coil center would be 0T.

The coils must be arranged radially outside a µ-metal shield so that their field is shielded by µ-metal when the field is below the saturation of the µ-metal.

A ferromagnetic µ-metal part is used in the Field Cycling Coils to maintain the same field homogeneity over the 100µT - 0.8T range.

The shape of the part and its thickness are optimized so that:
- At high fields: the ferromagnetic part is magnetically saturated, but the external non-homogeneous disturbance fields (earth's magnetic field, leakage field from the superconducting magnet and magnetic tunnel, etc.) are weak compared with the field from the zero-coil, so the expected field homogeneity is achieved.
- At low fields: the non-homogeneous external disturbance fields (earth's magnetic field, leakage field from the superconducting magnet and magnetic tunnel, etc.) are greater than that of the zero-coil. But since the field is weak, the ferromagnetic part channels the non-homogeneous external disturbance fields as well as the field of the coils, and homogeneity is maintained at very low field strength, having optimized the first two coils (inside the µ-metal part) for low field strength.

Using µ-metal parts is a passive solution to damp and shield any remaining low external magnetic field. In principle, the µ-metal part works independently of the orientation of the low remaining magnetic field. So one does not need extra shimming coils and power amplifiers.

In the frame of the present invention the terms *low field magnet system, field cycling coil* and *relaxation magnet* are used synonymously.

The transfer system according to the invention can easily be integrated into a commercial NMR spectrometer in a space-saving manner and is capable of moving an NMR sample container, which is fastened to the shuttle assembly, precisely between at least two adjustable measuring positions in less than 100ms.

The system can be adapted to existing or commercially available NMR spectrometers without any modification in the magnet bore.

### Preferred embodiments and further developments of the invention

In particularly preferred class of embodiments of the invention, the further magnet system of the magnetic tunnel comprises permanent magnets, preferably arranged in a Halbach dipole configuration with k=2.

The Halbach arrangement allows for intense magnetic field inside the tunnel and a very low stray field outside of the tunnel.

Preferably, in further developments of this class of embodiments the magnetic field generated by the further magnet system of the magnetic tunnel is directed perpendicular to the homogenous magnetic field parallel to a z-axis generated by the high field superconducting NMR magnet system.

Creating a field perpendicular to the tunnel axis is the most efficient direction for the Halbach arrangement. It allows minimizing the required amount of permanent magnets for a given field intensity.

In another advantageous embodiment, the further magnet system of the magnetic tunnel is designed for generating an adiabatic magnetic field with a flux density in a range from 0.5T to 1T.

The principle of the magnetic tunnel allows to preserve the life of polarized spins during rapid sample movement between the two magnetic fields, i.e. the high field superconducting magnet and the low field magnet system (=field cycling coil).

The solution according to the present invention allows using a field coil in the relaxation or field cycling magnet which is not actively shielded, i.e. an additional shield coil is not necessary. Consequently the relaxation magnet is more efficient in a way that a higher magnetic field can be achieved with the same current.

By using a magnetic tunnel, the field cycling coil can be positioned outside the superconducting magnet. Not being limited by the superconducting magnet bore allows for a bigger coil in the relaxation magnet and no need of an active shielding.

In a preferred further development of this embodiment, one end of the further magnet system of the magnetic tunnel is arranged in a region of the bore where the flux density of the homogenous magnetic field generated by the high field superconducting NMR magnet system has dropped to about 1T, such that the sample is never in a non-magnetic environment.

The direction of the magnetic field is not important. Before entering the field cycling coil, the sample is always exposed to a magnetic field of at least 1T. This ensures that the polarization is not lost during the transfer process.

A preferred embodiment of the invention is characterized in that the high field superconducting NMR magnet system is designed for generating a homogenous magnetic field in a range from 5T to 30T, in particular from 7.3T to 29.3T.

In present embodiments 600.13Mhz = 14.65 Tesla /700.13Mhz = 17.09 Tesla superconducting magnets are used, but in theory the present technology can go up to the Bruker ultra-high field magnets with 1.2GHz corresponding to 29.29 Tesla.

The higher the field the higher the resolution. By adjusting the ring-shaped permanent magnets (shimming rings) to the magnet, one can adapt the system to any superconducting magnet. In theory, one can even improve the system by using a higher field superconducting magnet. It is possible to adapt an existing system to a new magnet, for example if a customer wants to use a stronger magnet.

In an advantageous embodiment, the low field magnet system comprises a resistive coil-based electromagnet arrangement for field-cycling designed for generating a homogenous magnetic field with variable magnetic flux density in a range from 100µT to 1T.

This means that the low field magnet system can produce much lower magnetic fields compared to unshielded magnets in the prior art, which have a lower limit of 200µT. The low-field range of the device is therefore significantly expanded by this innovation.

Preferably, in variants of this embodiment the magnetic field generated by the electromagnet arrangement for field-cycling has a homogeneity of at least 10% along the NMR sample, preferably within a switching time of about 1ms or less. The exposure of the sample in a homogeneous and temporary stable magnetic field is important for the signal quality.

Advantageous is a further embodiment, wherein the low field magnet system for field-cycling is arranged directly above the high field superconducting NMR magnet system.

The field cycling coil is sufficiently distanced from the superconducting high field magnet such that magnetic coupling with the SC magnet can be avoided. The electrical power required for the same magnetic field is greatly reduced. Moreover, the water cooling of the relaxation magnet is more efficient because there more space for the cooling system. The extra radial space allows for having 12 coils and 6 water jackets and so to reach a maximum field of 0.8T as well as a high duty cycle.

In another preferred embodiment, the low field magnet system comprises ring-shaped permanent magnets with a radial magnetization relative to the z-axis, in particular designed for cancelling the magnetic stray field arising from the high field superconducting NMR magnet system.

Using permanent magnets is a passive solution so that no extra power or cooling is needed. It is easy to add axial adjustment of the rings. This allows for dealing with the variations in the stray field of the superconducting magnet by simply changing the axial position of the magnet rings.

In preferred embodiments of the invention, the shuttle system is designed for shuttling the NMR sample between the high field superconducting NMR magnet system and the low field magnet system in less than 100ms.

The polarization of the sample is ideally preserved by very fast shuttling through the adiabatic magnetic field of the magnetic tunnel.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Detailed description of the invention and drawings

The invention is shown in the drawings and is explained in more detail on the basis of illustrative embodiments.
- Fig. 1: shows a schematic vertical cross section through an NMR spectrometer with a modified magnetic tunnel according to the invention;
- Fig. 2: shows a schematic diagram of a preferred method of field cycling by using the two-field-NMR spectrometer according to the invention with the field cycling coil located at the upper end of the magnetic tunnel;
- Fig. 3: shows a sectional drawing through the magnetic tunnel with arrows indicating the direction of magnetic flux inside the hollow magnetic tunnel and inside the magnetic material establishing the tunnel;
- Fig. 4: shows in a schematic stereoscopic view a resistive coil-based electromagnet arrangement for field-cycling designed for generating a homogenous magnetic field with variable magnetic flux density and comprising a low field coil system arranged inside a cylindrical ferromagnetic part being surrounded by a high field coil system for generating magnetic fields at flux densities above the magnetic saturation of the ferromagnetic part; and
- Fig. 5: shows in a schematic stereoscopic partial view an embodiment of the low field permanent magnet system in an NMR spectrometer according to the invention comprising the resistive coil-based electromagnet arrangement for field-cycling as depicted in Fig. 4, the further magnet system of the magnetic tunnel and ring-shaped permanent magnets radially surrounding the further magnet system.

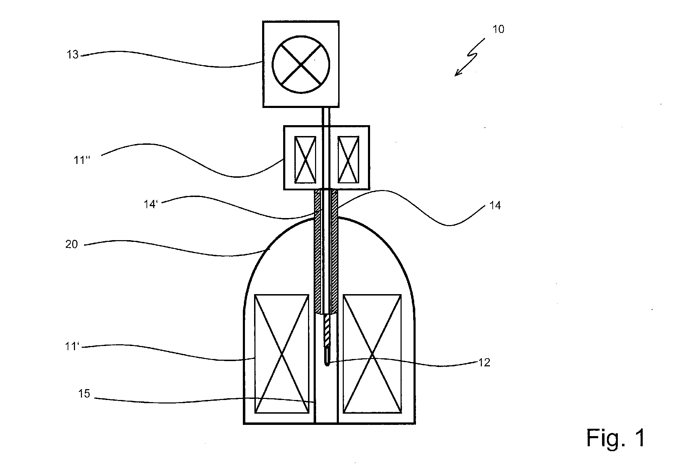

**Fig. 1** schematically depicts a **Two-Field-NMR spectrometer 10** for performing field-cycling NMR relaxometry experiments comprising
- a **high field superconducting NMR magnet system 11'** for generating a homogenous magnetic field parallel to a z-axis in a central region of the two-field-NMR spectrometer 10 for polarization of an **NMR sample 12** and for detection of NMR signals;
- a **low field magnet system 11"** generating a variable homogenous magnetic field;
- a **shuttle system 13** designed for shuttling the NMR sample 12 between the high field superconducting NMR magnet system 11' and the low field permanent magnet system 11"; and
- a **magnetic tunnel 14** connecting the center of the high field superconducting NMR magnet system 11' with the low field magnet system 11".

The Two-Field-NMR spectrometer 10 according to the invention is characterized by the magnetic tunnel 14 being provided with a **further magnet system 14'** and by the high field superconducting NMR magnet system 11', the magnetic tunnel 14 and the low field magnet system 11" being arranged coaxially about the z-axis along a **bore 15** of the high field superconducting NMR magnet system 11' contained in a **cryostat 20.**

The low field magnet system 11" for field-cycling is arranged directly above the high field superconducting NMR magnet system 11' for avoiding long sample transfer ways. Hence, the field cycling magnet has to eliminate the residual fields of the high field magnet and the tunnel magnets.

The shuttle system 13 is designed for shuttling the NMR sample 12 between the high field superconducting NMR magnet system 11' and the low field magnet system 11" in less than 100ms. Thus, the present invention uses a comparatively fast sample shuttling technique and it improves the loss of signal (polarization) during the shuttling. The low field magnet is arranged in close vicinity of the high field magnet, but outside the cryostat 20 of the high field magnet, which allows a short shuttling distance.

The basic idea of the invention was to design an improved Two-Field-NMR spectrometer 10 for performing field-cycling NMR having an excellent resolution at the high field part with magnetic fields of flux density up to 30T and being adapted to reach very low magnetic fields of flux density down to 100µT at the low field part of the apparatus.

The system according to the invention can easily be adapted to existing NMR spectrometers without any modification in the magnet bore.

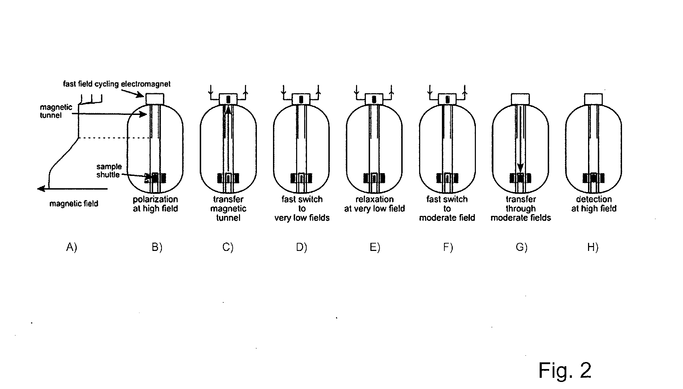

The schematic diagram of **Fig. 2** is depicting a preferred method of field cycling by using the two-field-NMR spectrometer according to the invention with the field cycling coil arranged above the superconducting high field magnet. The sample is shuttled between the high-field superconducting NMR magnet system 11' and the low-field NMR magnet system 11" through the magnetic tunnel 14.

Said method corresponds to the method according to the prior art in Reference [6], with the difference that the spectrometer uses a fast shuttle for a very fast transportation of the sample tube as disclosed in Reference [1] from the polarization magnet to the relaxation magnet. In addition, Reference [6] does not use a magnetic tunnel and thus they lose polarization and hence signal during the transfer.

This solution is to extend the average field zone from 0.5T to 1T towards the outside of the cryomagnet, by adding a magnetic tunnel (usually between 0.7T and 1T). This solution makes it possible to use a field cycling coil (relaxation magnet) without an additional shielding coil, i.e. one that is more efficient (more field with the same current). The electrical power required for the same field is greatly reduced, and water cooling is also more efficient (more space for the cooling system).

The schematic diagram of Fig. 2 presents a preferred mode of operation with the relaxation field coil moved outside the magnet and the magnetic tunnel added:
A) Shows the magnetic field evolution in z-direction long the bore. This represents the magnetic field strenghth to which the sample is exposed. The dotted line shows the lower end of the magnetic tunnel such that the field strenghth is maintained during the transfer of the sample from this distinct level (approx. 1T).
B) In the first step of the method, the sample is polarized in the high field magnet during a predefined exposure time.
C) The second step is the quick transfer of the sample to the FCC through the adiabatic magnetic tunnel.
D) The FCC can be switched quickly (1ms) to the pre-selected magnetic field (here: 100µT - 0,8T) for relaxation.
E) The sample is exposed to the relaxation field during a defined time period.
F) Optionally the FCC the sample can be changed to a moderate field.
G) The sample is then transferred back to the high field magnet.
H) The spectrum acquisition is performed in the high field magnet.

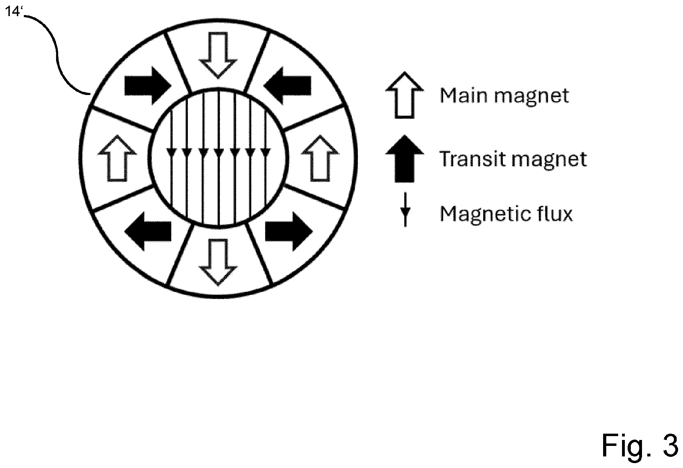

In a sectional drawing through the magnetic tunnel 14, **Fig. 3** shows an embodiment of the further magnet system 14' of the magnetic tunnel 14 comprising permanent magnets arranged in a Halbach dipole configuration with k=2. Arrows are indicating the direction of magnetic flux inside the hollow magnetic tunnel and inside the magnetic material establishing the tunnel.

The magnetic field generated by the further magnet system 14' of the magnetic tunnel 14 being designed for generating an adiabatic magnetic field with a flux density in a range from 0.7T to 1T is directed perpendicular to the homogenous magnetic field parallel to a z-axis generated by the high field superconducting NMR magnet system 11'.

One end of the further magnet system 14' of the magnetic tunnel 14 is arranged in a region of the bore 15 where the flux density of the homogenous magnetic field generated by the high field superconducting NMR magnet system 11' has dropped to about 1T.

Inside the ring of the further magnet system 14', a strong horizontal field is generated. By piling up many such rings, a long tunnel with constant horizontal field can be achieved.

The following assumptions were made:
- The permanent magnetic material used is NdFeB with a magnetic remanence of 1.39T.
- The inner radius of the ring is 8.5mm, the outer radius is 20mm. The resulting magnetic field inside the ring attains more than 1T.

The magnetic tunnel 14 in this example has a length of 600mm and starts axially at 400mm from the magnetic center of a 600MHz magnet and starts at 500mm from the magnetic center of a 700MHz magnet. It generates a field inhomogeneity which can be easily compensated with a room temperature shim system at the magnetic center of the cryomagnet.

To resume, the 2F NMR device according to the present invention comprises three distinct main magnetic elements:
a. The high field magnet for polarization
b. The magnetic tunnel
c. The Field Cycling Coil ("FCC") for relaxation
   a) The high field polarization magnet is generally the superconducting NMR Magnet which can be chosen e.g. from 7.3T to 29.3T
   b) The magnetic tunnel is constituted of permanent magnets in the Halbach configuration. Producing an adiabatic magnetic field at a field strength of 0.5T to 1.5T depending on the nucleus. The magnetic tunnel is important for preserving the spin polarization during the transfer between the magnets a) and c).
      The magnetic tunnel is arranged in the bore of the superconducting magnet, where the field strength has dropped to about 1T such that the sample is never in a non-magnetic environment, preferably never below a magnetic field of 0.7T. The direction of the magnetic field is not important; the superconducting magnet and the FCC both produce a field in z-direction along the common bore while the magnetic tunnel produces a perpendicular field in x-direction due to the Halbach configuration.
   c) The Field Cycling Coil or fast field cycling magnet (FCC) is an electromagnet, which can be varied from 100µT to 1T in a very short time of 1ms. This magnet is not actively shielded, but its design permits to be independent from the magnetic field of the high field magnet in Z-direction, the field of the magnetic tunnel in x-direction and the earth magnetic field. The FFC magnet must have a homogeneity of at least 10% along the sample.

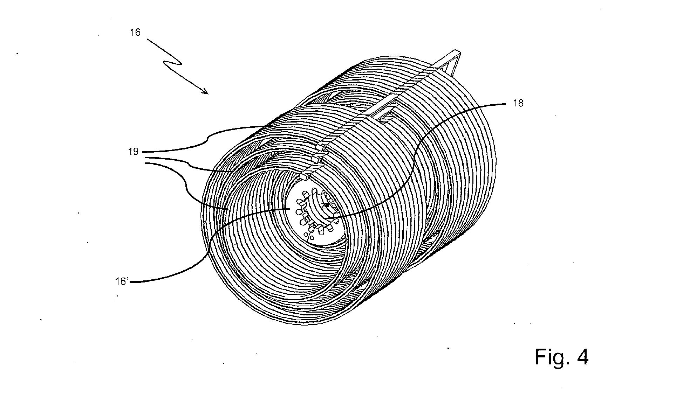

**Fig. 4** illustrates in a schematic stereoscopic view an important detail of a preferred embodiment of the Two-Field-NMR spectrometer 10 according to the invention:
Here, the low field magnet system 11" comprises a **resistive coil-based electromagnet arrangement 16** for field-cycling designed for generating a homogenous magnetic field with variable magnetic flux density in a range from 100µT to 1T and a homogeneity of at least 10% along the NMR sample 12, preferably within a switching time of about 1ms or less.

The low field permanent magnet system 11" comprises a **cylindrical ferromagnetic part 16',** in particular comprising µ-metal, for shielding non-homogeneous external magnetic disturbance fields at low flux densities.

Further, the low field permanent magnet system 11" comprises at least one **low field coil 18** arranged inside the cylindrical ferromagnetic part 16' designed for producing magnetic fields at flux densities below the magnetic saturation of the ferromagnetic part 16'.

In addition, the low field permanent magnet system 11" comprises at least one **high field coil 19** arranged outside the cylindrical ferromagnetic part 16' for generating magnetic fields at flux densities above the magnetic saturation of the ferromagnetic part 16'.

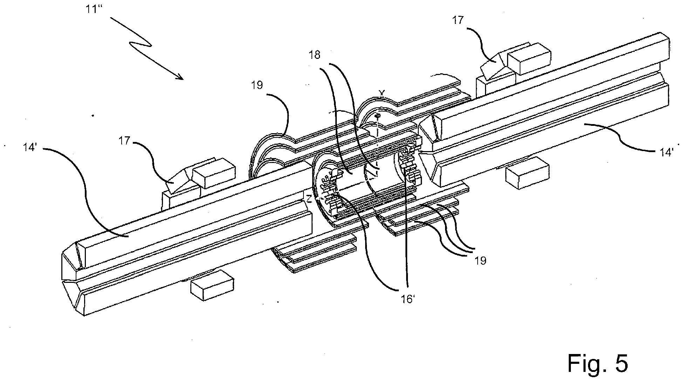

**Fig. 5** illustrates in a schematic stereoscopic partial view an embodiment of the low field permanent magnet system in a Two-Field-NMR spectrometer 10 according to the invention comprising the resistive coil-based electromagnet arrangement 16 for field-cycling as depicted in Fig. 4, the further magnet system 14' of the magnetic tunnel 14 and **ring-shaped permanent magnets 17** radially surrounding the further magnet system 14' with a radial magnetization relative to the z-axis.

This additional system of ring-shaped permanent magnets 17 is designed for cancelling the magnetic stray field arising from the high field superconducting NMR magnet system 11' in order to achieve the very low field of about 100µT.

The amplitude of superconducting magnet stray field of the high field superconducting NMR magnet system 11' is about 10mT at the center of the coils of the low field permanent magnet system 11". The rings are radially magnetized in opposite direction to create a constant magnetic field with a gradient along the z axis.

Preferred embodiment of the magnetic tunnel:
In High Resolution Two Field NMR, an NMR sample is shuttled between a high field (e.g. 14T) and a low field (e.g. 3T). Since the sample is not allowed to lose its polarization, the path between high field and low field must be in a background field as high as possible. The field direction is unimportant.

The preferred concept for Two Field NMR according to the invention is to add a low field magnet on top of the high field magnet. In the path between the two magnetic centers, a magnetic tunnel made of Halbach arrays can maintain a minimum flux density.

### List of reference signs:

- 10: Two-Field-NMR spectrometer
- 11': high-field superconducting NMR magnet system
- 11": low-field NMR magnet system
- 12: NMR sample
- 13: shuttle system
- 14: magnetic tunnel
- 14': further magnet system
- 15: bore of the high field superconducting NMR magnet system
- 16: resistive coil-based electromagnet arrangement for field-cycling
- 16': cylindrical ferromagnetic part, in particular comprising µ-metal
- 17: ring-shaped permanent magnets
- 18: low field coil arranged inside the cylindrical ferromagnetic part
- 19: high field coil arranged outside the cylindrical ferromagnetic part
- 20: NMR cryostat

### List of prior art citations:

Publications considered for assessing patentability of the present invention:
[1] EP 4 071 492 B1 ≈ CN 115201728 B ≈ US 11,474,172 B1
[2] R. Kimmich et al., "Field-cycling NMR relaxometry", Progress in Nuclear Magnetic Resonance Spectroscopy 44 (2004) 257-320
[3] EP 3 081 954 B1
[4] US 2016/0076924 A1
[5] WO 2011/151049 A1
[6] I. V. Zhoukov et al., "Field-cycling NMR experiments in an ultra-wide magnetic field range: relaxation and coherent polarization transfer", Phys. Chem. Chem. Phys., 2018, 20, 12396-12405
[7] US 11,579,224 B2 ≈ EP 4 006 567 B1 ≈ DE10 2020 214 887 B4
[8] Alexey S. Kiryutin et al.: "A fast field-cycling device for high-resolution NMR: Design and application to spin relaxation and hyperpolarization experiments", JOURNAL OF MAGNETIC RESONANCE, vol. 263, 1 February 2016 (2016-02-01), pages 79-91, XP055547226, US ISSN: 1090-7807, DOI: 10.1016/j.jmr. 2015.11.017

## Claims

1. Two-Field-NMR spectrometer (10) for performing field-cycling NMR relaxometry experiments comprising
- a high field superconducting NMR magnet system (11') for generating a homogenous magnetic field parallel to a z-axis in a central region of the two-field-NMR spectrometer (10) for polarization of an NMR sample (12) and for detection of NMR signals;
- a low field magnet system (11") arranged to generate a variable homogenous magnetic field;
- a magnetic tunnel (14) connecting the center of the high field superconducting NMR magnet system (11') with the low field magnet system (11");
and
- a shuttle system (13) designed for shuttling the NMR sample (12) between the high field superconducting NMR magnet system (11') and the low field magnet system (11");
wherein the magnetic tunnel (14) is provided with a further magnet system (14'); and
wherein the high field superconducting NMR magnet system (11'), the magnetic tunnel (14) and the low field magnet system (11") are arranged coaxially about the z-axis along a bore (15) of the high field superconducting NMR magnet system (11'),
**characterized in**
**that** the low field permanent magnet system (11") comprises a cylindrical ferromagnetic part (16'), in particular comprising µ-metal, for shielding non-homogeneous external magnetic disturbance fields at low flux densities;
**that** the low field system (11") comprises a low field coil (18) arranged inside the cylindrical ferromagnetic part (16') configured to produce magnetic fields at flux densities below the magnetic saturation of the ferromagnetic part (16'); and
**that** the low field system (11") comprises a high field coil (19) arranged outside the cylindrical ferromagnetic part (16') configured to generate magnetic fields at flux densities above the magnetic saturation of the ferromagnetic part (16').

2. NMR spectrometer according to claim 1, **characterized in that** the further magnet system (14') of the magnetic tunnel (14) comprises permanent magnets, preferably arranged in a Halbach dipole configuration with k=2.

3. NMR spectrometer according to claim 2, **characterized in that** the magnetic field generated by the further magnet system (14') of the magnetic tunnel (14) is directed perpendicular to the homogenous magnetic field parallel to a z-axis generated by the high field superconducting NMR magnet system (11').

4. NMR spectrometer according to anyone of the preceding claims, **characterized in that** the further magnet system (14') of the magnetic tunnel (14) is designed for generating a magnetic field with a flux density in a range from 0.7T to 1T.

5. NMR spectrometer according to anyone of the preceding claims, **characterized in that** one end of the further magnet system (14') of the magnetic tunnel (14) is arranged in a region of the bore (15) where the flux density of the homogenous magnetic field generated by the high field superconducting NMR magnet system (11') has dropped to about 1T.

6. NMR spectrometer according to anyone of the preceding claims, **characterized in that** the high field superconducting NMR magnet system (11') is designed for generating a homogenous magnetic field in a range from 5T to 50T, in particular from 7.3T to 29.3T.

7. NMR spectrometer according to anyone of the preceding claims, **characterized in that** the low field magnet system (11") comprises a resistive coil-based electromagnet arrangement (16) for field-cycling designed for generating a homogenous magnetic field with variable magnetic flux density in a range from 100µT to 1T.

8. NMR spectrometer according to claim 7, **characterized in that** the magnetic field generated by the electromagnet arrangement (16) for field-cycling has a homogeneity of at least 10% along the NMR sample (12), preferably within a switching time of about 1ms or less.

9. NMR spectrometer according to anyone of the preceding claims, **characterized in that** the low field magnet system (11") for field-cycling is arranged directly above the high field superconducting NMR magnet system (11').

10. NMR spectrometer according to anyone of the preceding claims, **characterized in that** the low field magnet system (11") in addition to the further magnet system (14') comprises ring-shaped permanent magnets (17) with a radial magnetization relative to the z-axis, designed for cancelling the magnetic stray field arising from the high field superconducting NMR magnet system (11').

11. NMR spectrometer according to anyone of the preceding claims, **characterized in that** the shuttle system (13) is designed for shuttling the NMR sample (12) between the high field superconducting NMR magnet system (11') and the low field magnet system (11") in less than 100ms.

## Patentansprüche

1. Zwei-Feld-NMR (Two-Field-NMR) Spektrometer (10) zur Durchführung von NMR Relaxometrie Experimenten mit variierenden Feldern (field-cycling), umfassend
- ein supraleitendes Hochfeld NMR Magnetsystem (11') zum Erzeugen eines homogenen Magnetfelds parallel zu einer z-Achse in einem zentralen Bereich des Zwei-Feld-NMR Spektrometers (10) zum Polarisieren einer NMR Probe (12) und zum Detektieren von NMR Signalen;
- ein Niederfeld Magnetsystem (11"), das so angeordnet ist, dass es ein variables homogenes Magnetfeld erzeugt;
- einen Magnettunnel (14), der das Zentrum des supraleitenden Hochfeld NMR Magnetsystems (11') mit dem Niederfeld Magnetsystem (11") verbindet;
und
- ein Shuttlesystem (13), das zum Transportieren der NMR Probe (12) zwischen dem supraleitenden Hochfeld NMR Magnetsystem (11') und dem Niederfeld Magnetsystem (11") ausgelegt ist;
wobei der Magnettunnel (14) mit einem weiteren Magnetsystem (14') versehen ist; und
wobei das supraleitende Hochfeld NMR Magnetsystem (11'), der Magnettunnel (14) und das Niederfeld Magnetsystem (11") koaxial um die z-Achse entlang einer Bohrung (15) des supraleitenden Hochfeld NMR Magnetsystems (11') angeordnet sind,
**dadurch gekennzeichnet,**
**dass** das Niederfeld Permanentmagnetsystem (11") einen zylindrischen ferromagnetischen Teil (16'), insbesondere umfassend µ-Metall, zum Abschirmen von inhomogenen externen magnetischen Störfeldern bei niedrigen Flussdichten umfasst;
**dass** das Niederfeldsystem (11") eine Niederfeldspule (18) umfasst, die innerhalb des zylindrischen ferromagnetischen Teils (16') angeordnet ist und so konfiguriert ist, dass sie Magnetfelder mit Flussdichten unterhalb der magnetischen Sättigung des ferromagnetischen Teils (16') erzeugt; und
**dass** das Niederfeldsystem (11") eine außerhalb des zylindrischen ferromagnetischen Teils (16') angeordnete Hochfeldspule (19) umfasst, die so konfiguriert ist, dass sie Magnetfelder mit Flussdichten oberhalb der magnetischen Sättigung des ferromagnetischen Teils (16') erzeugt.

2. NMR Spektrometer nach Anspruch 1, **dadurch gekennzeichnet, dass** das weitere Magnetsystem (14') des Magnettunnels (14) Permanentmagnete umfasst, die vorzugsweise in einer Halbach-Dipol-Konfiguration mit k=2 angeordnet sind.

3. NMR Spektrometer nach Anspruch 2, **dadurch gekennzeichnet, dass** das von dem weiteren Magnetsystem (14') des Magnettunnels (14) erzeugte Magnetfeld senkrecht zu dem von dem supraleitenden Hochfeld NMR Magnetsystem (11') erzeugten homogenen Magnetfeld parallel zu einer z-Achse ausgerichtet ist.

4. NMR Spektrometer nach einem der vorhergehenden Ansprüche, **dadurch gekennzeichnet, dass** das weitere Magnetsystem (14') des Magnettunnels (14) zur Erzeugung eines Magnetfelds mit einer Flussdichte in einem Bereich von 0,7 T bis 1 T ausgelegt ist.

5. NMR Spektrometer nach einem der vorhergehenden Ansprüche, **dadurch gekennzeichnet, dass** ein Ende des weiteren Magnetsystems (14') des Magnettunnels (14) in einem Bereich der Bohrung (15) angeordnet ist, in dem die Flussdichte des durch das supraleitende Hochfeld NMR Magnetsystem (11') erzeugten homogenen Magnetfelds auf etwa 1 T abgefallen ist.

6. NMR Spektrometer nach einem der vorhergehenden Ansprüche, **dadurch gekennzeichnet, dass** das supraleitende Hochfeld NMR Magnetsystem (11') zur Erzeugung eines homogenen Magnetfelds in einem Bereich von 5 T bis 50 T, insbesondere von 7,3 T bis 29,3 T, ausgelegt ist.

7. NMR Spektrometer nach einem der vorhergehenden Ansprüche, **dadurch gekennzeichnet, dass** das Niederfeld Magnetsystem (11") eine resistive spulenbasierte Elektromagnetanordnung (16) zum Variieren der Felder (field-cycling) umfasst, die zur Erzeugung eines homogenen Magnetfelds mit variabler Magnetflussdichte in einem Bereich von 100 µT bis 1 T ausgelegt ist.

8. NMR Spektrometer nach Anspruch 7, **dadurch gekennzeichnet, dass** das von der Elektromagnetanordnung (16) für das Variieren der Felder (field-cycling) erzeugte Magnetfeld eine Homogenität von mindestens 10 % entlang der NMR Probe (12) aufweist, vorzugsweise innerhalb einer Schaltzeit von etwa 1 ms oder weniger.

9. NMR Spektrometer nach einem der vorhergehenden Ansprüche, **dadurch gekennzeichnet, dass** das Niederfeld Magnetsystem (11") für das Variieren der Felder (field-cycling) direkt über dem supraleitenden Hochfeld NMR Magnetsystem (11') angeordnet ist.

10. NMR Spektrometer nach einem der vorhergehenden Ansprüche, **dadurch gekennzeichnet, dass** das Niederfeld Magnetsystem (11") zusätzlich zu dem weiteren Magnetsystem (14') ringförmige Permanentmagnete (17) mit einer radialen Magnetisierung relativ zur z-Achse umfasst, die dazu ausgelegt sind, das vom supraleitenden Hochfeld NMR Magnetsystem (11') ausgehende magnetische Streufeld aufzuheben.

11. NMR Spektrometer nach einem der vorhergehenden Ansprüche, **dadurch gekennzeichnet, dass** das Shuttlesystem (13) dazu ausgelegt ist, die NMR Probe (12) in weniger als 100 ms zwischen dem supraleitenden Hochfeld NMR Magnetsystem (11') und dem Niederfeld Magnetsystem (11") zu transportieren.

## Revendications

1. Spectromètre RMN à deux champs (10) pour réaliser des expérimentations de relaxométrie RMN à cyclage de champ, comprenant :
- un système d'aimant(s) RMN de supraconduction à champ élevé (11') pour générer un champ magnétique homogène parallèle à un axe z dans une région centrale du spectromètre RMN à deux champs (10) pour la polarisation d'un échantillon RMN (12) et pour la détection de signaux RMN ;
- un système d'aimant(s) à champ faible (11") agencé pour générer un champ magnétique homogène variable ;
- un tunnel magnétique (14) qui connecte le centre du système d'aimant(s) RMN de supraconduction à champ élevé (11') avec le système d'aimant(s) à champ faible (11") ; et
- un système de navette (13) conçu pour faire faire la navette à l'échantillon RMN (12) entre le système d'aimant(s) RMN de supraconduction à champ élevé (11') et le système d'aimant(s) à champ faible (11") ;
dans lequel le tunnel magnétique (14) est muni d'un système d'aimant(s) supplémentaire (14') ; et
dans lequel le système d'aimant(s) RMN de supraconduction à champ élevé (11'), le tunnel magnétique (14) et le système d'aimant(s) à champ faible (11") sont agencés de façon coaxiale autour de l'axe z le long d'un alésage (15) du système d'aimant(s) RMN de supraconduction à champ élevé (11'),
**caractérisé en ce que** :
le système d'aimant(s) permanent(s) à champ faible (11") comprend une partie ferromagnétique cylindrique (16'), en particulier comprenant du µ-métal, pour assurer une protection vis-à-vis de champs de perturbations magnétiques externes non homogènes à des densités de flux faibles ; **en ce que** :
le système d'aimant(s) à champ faible (11") comprend une bobine à champ faible (18) qui est agencée à l'intérieur de la partie ferromagnétique cylindrique (16') et qui est configurée pour produire des champs magnétiques à des densités de flux en deçà de la saturation magnétique de la partie ferromagnétique (16') ; et **en ce que** :
le système d'aimant(s) à champ faible (11") comprend une bobine à champ élevé (19) qui est agencée à l'extérieur de la partie ferromagnétique cylindrique (16') et qui est configurée pour générer des champs magnétiques à des densités de flux au-delà de la saturation magnétique de la partie ferromagnétique (16').

2. Spectromètre RMN selon la revendication 1, **caractérisé en ce que** le système d'aimant(s) supplémentaire (14') du tunnel magnétique (14) comprend des aimants permanents, de préférence agencés selon une configuration dipolaire de Halbach avec k = 2.

3. Spectromètre RMN selon la revendication 2, **caractérisé en ce que** le champ magnétique qui est généré par le système d'aimant(s) supplémentaire (14') du tunnel magnétique (14) est dirigé perpendiculairement au champ magnétique homogène parallèle à l'axe z qui est généré par le système d'aimant(s) RMN de supraconduction à champ élevé (11').

4. Spectromètre RMN selon l'une quelconque des revendications précédentes, **caractérisé en ce que** le système d'aimant(s) supplémentaire (14') du tunnel magnétique (14) est conçu pour générer un champ magnétique avec une densité de flux dans une plage de 0,7 T à 1 T.

5. Spectromètre RMN selon l'une quelconque des revendications précédentes, **caractérisé en ce qu'**une extrémité du système d'aimant(s) supplémentaire (14') du tunnel magnétique (14) est agencée dans une région de l'alésage (15) au niveau de laquelle la densité de flux du champ magnétique homogène qui est généré par le système d'aimant(s) RMN de supraconduction à champ élevé (11') a chuté jusqu'à environ 1 T.

6. Spectromètre RMN selon l'une quelconque des revendications précédentes, **caractérisé en ce que** le système d'aimant(s) RMN de supraconduction à champ élevé (11') est conçu pour générer un champ magnétique homogène dans une plage de 5 T à 50 T, en particulier de 7,3 T à 29,3 T.

7. Spectromètre RMN selon l'une quelconque des revendications précédentes, **caractérisé en ce que** le système d'aimant(s) à champ faible (11") comprend un agencement d'électro-aimant(s) à base de bobine(s) résistive(s) (16) pour le cyclage de champ qui est conçu pour générer un champ magnétique homogène avec une densité de flux magnétique variable dans une plage de 100 µT à 1 T.

8. Spectromètre RMN selon la revendication 7, **caractérisé en ce que** le champ magnétique qui est généré par l'agencement d'électro-aimant(s) (16) pour le cyclage de champ présente une homogénéité d'au moins 10 % le long de l'échantillon RMN (12), de préférence à l'intérieur d'un temps de commutation d'environ 1 ms ou moins.

9. Spectromètre RMN selon l'une quelconque des revendications précédentes, **caractérisé en ce que** le système d'aimant(s) à champ faible (11") pour le cyclage de champ est agencé directement au-dessus du système d'aimant(s) RMN de supraconduction à champ élevé (11')

10. Spectromètre RMN selon l'une quelconque des revendications précédentes, **caractérisé en ce que** le système d'aimant(s) à champ faible (11") en plus du système d'aimant(s) supplémentaire (14') comprend des aimants permanents en forme de bague (17) avec une magnétisation radiale par rapport à l'axe z, conçus pour annuler le champ magnétique parasite ou de fuite en provenance du système d'aimant(s) RMN de supraconduction à champ élevé (11').

11. Spectromètre RMN selon l'une quelconque des revendications précédentes, **caractérisé en ce que** le système de navette (13) est conçu pour faire faire la navette à l'échantillon RMN (12) entre le système d'aimant(s) RMN de supraconduction à champ élevé (11') et le système d'aimant(s) à champ faible (11") en moins de 100 ms.
